Europäisches Patentamt

**(19)** European Patent Office

Office européen des brevets

**(11)** Publication number : **0 289 174 B1**

**(12)** EUROPEAN PATENT SPECIFICATION

**(45)** Date of publication of patent specification :
09.11.94 Bulletin 94/45

**(51)** Int. Cl.⁵ : **G03F 7/09,** G03F 7/26

**(21)** Application number : **88303400.1**

**(22)** Date of filing : **15.04.88**

**(54)** Antireflection coatings for use in photolithography.

**(30)** Priority : **24.04.87 US 42402**

**(43)** Date of publication of application :
**02.11.88 Bulletin 88/44**

**(45)** Publication of the grant of the patent :
**09.11.94 Bulletin 94/45**

**(84)** Designated Contracting States :
**AT BE CH DE ES FR GB GR IT LI LU NL SE**

**(56)** References cited :
EP-A- 0 098 582
EXTENDED ABSTRACTS OF THE
ELECTROCHEMICAL SOCIETY, vol. 87-2, no.
2, 1987, pages 671-672, abstract no. 477, Prin-
ceton, New Jersey, US; S. CHAMBERS: "Tin
ARC / hillock supression coating"
LE VIDE, LES COUCHES MINCES, vol. 218,
August/September/October 1983, pages
401-404; A. ARMIGLIATO et al.: "Optical and
electrical properties of ion implanted titanium
nitride thin films"

**(73)** Proprietor : **ADVANCED MICRO DEVICES,
INC.**
**901 Thompson Place**
**P.O. Box 3453**
**Sunnyvale, CA 94088 (US)**

**(72)** Inventor : **Arnold, William H., III**
**10381 Malvern Court**
**Cupertino California 94104 (US)**
Inventor : **Farnaam, Mohammad**
**1730 Halford Avenue**
**No. 349 Santa Clara, California 95051 (US)**
Inventor : **Sliwa, Jack**
**12700 Viscaino Road**
**Los Altos Hills California 94022 (US)**

**(74)** Representative : **Sanders, Peter Colin
Christopher et al**
**BROOKES & MARTIN**
**High Holborn House**
**52/54 High Holborn**
**London WC1V 6SE (GB)**

## Description

The present invention relates to photolithographic techniques in semiconductor processing, and, more particularly, to high resolution optical lithography using the g-, h-, or i-lines of the mercury spectrum for exposure of photolithographic films on a highly reflective surface, such as aluminum or titanium.

In the construction of integrated circuit devices, one or more metallic layers, such as aluminum or titanium, are deposited and subsequently patterned to provide ohmic or Schottky contacts and electrical connections between various circuit elements. Conventionally, photoresist is spun over the metallic layer and then exposed to a light pattern and developed. The normally aluminum metallic layer is then selectively plasma-etched with chlorine-containing gases through the openings in the resist layer. The remaining photoresist is then removed, leaving the final metal pattern.

Antireflective coatings have been used over reflective surfaces such as aluminum or titanium to improve resist patterning control by reducing interference effects and diffuse scattering, particularly if the illumination is monochromatic. Such effects have become less and less tolerable as linewidth and pitch have been reduced in newer integrated circuit designs of greater density.

One approach to reduce the reflected light has been to use metal or refractory materials as antireflective films on aluminum. Examples of such materials include titanium-tungsten (TiW) and molybdenum disilicide ($MoSi_2$). Van den Berg et al in "Antireflective Coatings on Metal Layers for Photolithographic Purposes", Journal of Applied Physics, Vol. 50, No. 3, pp. 1212-1214 (March 1979) proposed the use of amorphous silicon, amorphous selenium and chromium oxide as antireflective coatings. However, amorphous silicon reduces aluminum reflectance at a wavelength 436 nm to only about 15 to 20%, and its deposition characteristically introduces numerous harmful particulates.

The use of organic coatings, such as a thin polyimide with a light absorbing dye, has been described by Brewer et al in "The Reduction of the Standing Wave Effect in Positive Photoresists", Journal of Applied Photographic Engineering, Vol, 7, No. 6, pp. 184-186 (December 1981). However, this technique requires a separate polyimide spin and cure. The curing technique has proved difficult to control properly on the production line because of the tight temperature tolerances required.

In Le Vide, Les Couches Minces, vol. 218, August/September/October 1983, pp 401-404, it is suggested that titanium nitride might be used as an anti-reflective coating on a silicon wafer.

In EP-A-0,098,582 it is proposed to use a light-absorbing film between the metal surface and the photoresist when producing a patterned metal layer in a semiconductor chip, the light-absorbing film consisting of silicon nitride, silicon oxide, aluminum oxide or amorphous silicon. The thickness of the light-absorbing film ranges from 100 to 500 nm, and the amount of light reflected from the metal surface is reduced to not more than 30% of the incident light.

According to the present invention there is provided a method of preparing a wafer surface in an integrated circuit structure for patterning by photolithographic techniques, wherein the wafer surface is a highly reflective aluminum or titanium surface and the surface is coated with an antireflective film before forming a layer of photoresist over the surface, characterised in that the antireflective film consists of titanium nitride, and the titanium nitride is coated to a thickness of between 30 and 50nm for an aluminum surface and between 15 and 35nm for a titanium surface, whereby the amount of light reflected from the surface is reduced to less than about 5% of the incident radiation.

The TiN layer is preferably formed to a thickness which will provide the minimum reflectance into the photoresist layer at a preselected wavelength of light, i.e., the optical radiation employed in the photolithographic exposure process. The TiN layer thicknesses for the wavelengths primarily used in photolithography to achieve minimum reflectance into the overlying resist layer are as follows:

| Wavelength | TiN Thickness Range | |
| --- | --- | --- |
| | Aluminum | Titanium |
| 365 nm (i) | 30 - 40 nm | 15 - 25 nm |
| 405 nm (h) | 35 - 45 nm | 20 - 30 nm |
| 436 nm (g) | 40 - 50 nm | 25 - 35 nm |

However, it will be appreciated that other wavelengths may be employed, and the determination of the optimum TiN thickness for such wavelengths is easily made. The calculation of the TiN thicknesses to give the minimum reflectance is based on the optical properties found in Martin et al, "Optical Properties of $TiN_X$ Produced by Reactive Evaporation and Reactive Ion-Beam Sputtering", Vacuum, Vol, 32, pp. 359-362 (1982).

In the accompanying drawings, by way of example only:-

FIGS. 1a-c are a cross-sectional view of a portion of an integrated circuit structure illustrating a process embodying the invention;

FIG. 2 is a plot of reflectance as a function of TiN thickness for an aluminium layer; and

FIG. 3 is a plot of reflectance as a function of TiN thickness for a titanium layer.

The drawings are not to scale except if specifically noted. Moreover, the drawings illustrate only one portion of an integrated circuit fabricated in accordance with the present invention.

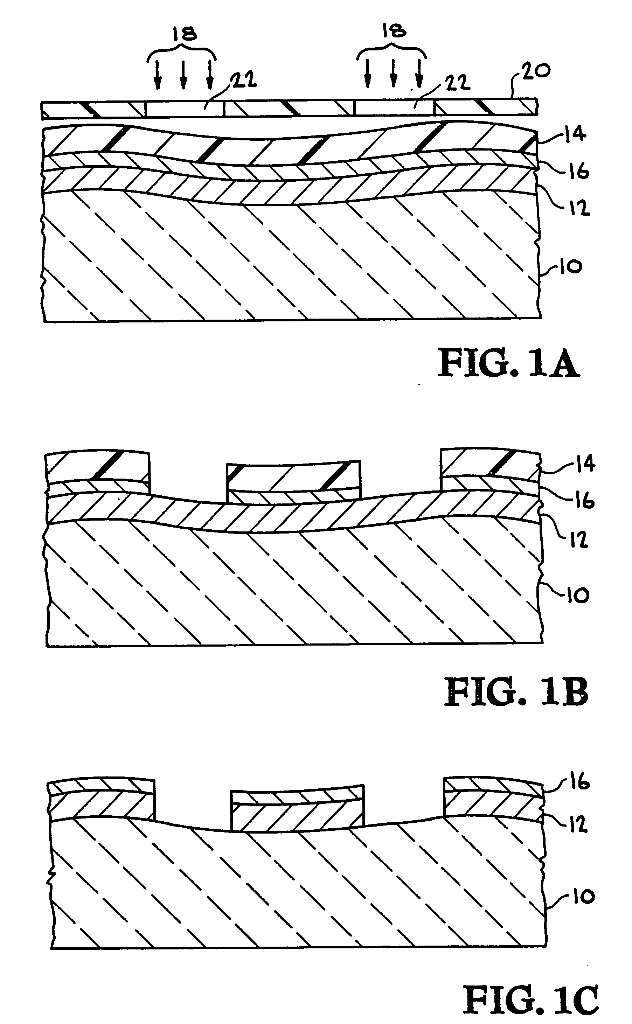

Fig. 1a depicts a cross-sectional view of a portion of an integrated circuit structure, shown generally at 10, having a highly reflective metal layer 12 formed thereon. Metal layers particularly benefitted by the practice of the invention include aluminum and titanium, and accordingly, these layers are preferred.

The metal layer 12 is formed in accordance with conventional present practice, and thus does not form a part of this invention. While the metal layer 12 is described herein as preferably comprising aluminum or titanium, it will be appreciated that the teachings of the invention are applicable to layers of other reflective materials, such as tungsten and Ti on polysilicon, which are to be patterned using photolithographic processes. For such other materials, the TiN thickness to provide antireflection will be different. However, such determination is easily made, as discussed below.

While it is desired to form a photoresist layer 14 on the metal layer 12 as part of the patterning process, it has been shown above that reflective light from the surface of the metal layer interferes with high resolution optical lithography. Accordingly, an antireflective layer 16 is first formed on the surface of the metal layer 12. The photoresist layer 14 is then formed on the surface of the antireflective layer 16. The photoresist layer 14 is formed by conventional methods, such as spinning a solution of the photoresist in a solvent on the surface of the antireflective layer 16. The solvent is allowed to dry, leaving the photoresist layer 14.

In accordance with the invention, the antireflective layer 16 comprises titanium nitride (TiN). The thickness to which the TiN layer 16 is formed depends upon the wavelength employed in the photolithographic process and on the optical properties of the underlying metal layer 12, and will be discussed in greater detail below. The process of depositing the TiN layer 16 is again conventional; examples include sputtering or evaporating titanium from a titanium target in an argon/nitrogen ambient, chemical vapor deposition (CVD) from a suitable source, and sputtering, evaporation or CVD of titanium onto a substrate and annealing the coated substrate in nitrogen ambient.

The TiN layer 16 formed comprises essentially stoichiometric TiN, although the nitrogen-to-titanium atomic ratio may vary about ±10%.

In FIG. 1a, light, represented by arrows 18, is incident on a mask 20, which is provided with apertures 22. The light, or optical radiation, 18 passes only through those apertures 22 to expose those portions of the resist layer 14 underlying the apertures, thereby patterning the resist. Such a process is conventional, and forms no part of this invention.

After resist exposure, the resist layer 14 is developed in a conventional solvent to remove those portions of the exposed resist. Next, those portions of the TiN layer 16 underlying the portions of exposed resist are etched, thereby uncovering portions of the metal layer 12. Such etching of TiN may be done by plasma etching in a fluorine-containing gas, for example. FIG. 1b depicts the cross-sectional view of the integrated circuit structure at this stage in the processing.

Following the TiN etch, the uncovered portions of the underlying metal layer 12 are etched, such as by plasma etching in a chlorine-containing gas. The remaining portions of the resist layer 14 are then removed, such as by plasma stripping in an oxygen plasma. The resulting structure is shown in FIG. 1c.

The TiN layer 16 may either be retained as a hillock suppression layer for a metal layer 12 of aluminum, as shown in FIG. 1c. As is known, if a layer of aluminum (pure or in the form of an alloy) is deposited on a silicon wafer at a temperature, and if subsequently the temperature of the wafer is raised substantially above the deposition temperature, then aluminum undergoes a compressive stress which results in migration of aluminum material from the aluminum/underlayer interface towards the surface of the aluminum layer, forming nodules sticking out of the surface at heights which can be as much as ten times the thickness of the aluminum layer. If there is already a layer of silicon dioxide or a refractory material on the surface of the aluminum, then the formation of these nodules, which are called "hillocks", is suppressed.

Alternatively, the TiN layer 16 may be removed, such as by stripping, using fluorine chemistry. As an example, a mixture of $O_2$ and $CHF_3$ in a reactive ion etcher may be used.

Use of the titanium nitride layer 16 in accordance with the invention minimizes standing wave interference in the resist layer 14 due to reflection, resist notching due to light scattering from the surface of the metal layer 12, and flare in the stepper optics due to light reflected back from the wafer. The TiN layer 16 also suppresses hillock formation in aluminum layers.

The reflectance into the resist layer 14 obtained using a TiN layer 16 can be less than about 5%, depending on the thickness chosen and the metal layer 12. Reflectances less than about 2% can be achieved with an aluminum layer 12.

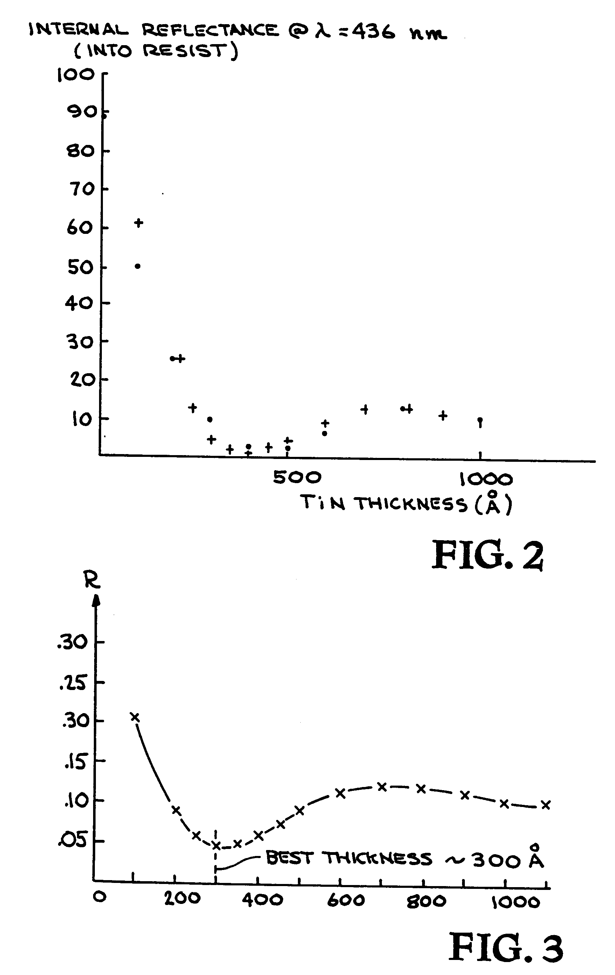

The thickness of the TiN layer 16 is a function of the wavelength of the incident optical radiation 18, as shown in FIGS. 2 (for aluminum) and 3 (for titanium). For particular wavelengths of the mercury spectrum (g-, h-, and i-lines), the thickness range for TiN on aluminum and on titanium associated with a particular wavelength is as follows:

| Wavelength | TiN Thickness Range | |
|---|---|---|
| | Aluminum | Titanium |
| 365 nm (i) | 300 - 400 A | 150 - 250 A |
| 405 nm (h) | 350 - 450 A | 200 - 300 A |
| 436 nm (g) | 400 - 500 A | 250 - 350 A. |

However, it will be appreciated that other wavelengths may be employed in the practice of the invention, and the determination of the optimum TiN thickness for such wavelengths is easily made by measuring reflectance as a function of thickness.

The foregoing description of the preferred embodiment of the present invention has been presented for purposes of illustration and description. It is not intended to be exhaustive or to limit the invention to the precise form disclosed. Obviously, many modifications and variations will be apparent to practitioners skilled in this art. It is possible that the invention may be practiced in other fabrication technologies in MOS or bipolar processes. Similarly, any process steps described might be interchangeable with other steps in order to achieve the same result. The embodiment was chosen and described in order to best explain the principles of the invention and its practical application, thereby enabling others skilled in the art to understand the invention for various embodiments and with various modifications as are suited to the particular use contemplated.

## Claims

1. A method of preparing a wafer surface (12) in an integrated circuit structure for patterning by photolithographic techniques, wherein the wafer surface (12) is a highly reflective aluminum or titanium surface and the surface is coated with an antireflective film (16) before forming a layer (14) of photoresist over the surface, characterised in that the antireflective film (16) consists of titanium nitride, and the titanium nitride is coated to a thickness of between 30 and 50nm for an aluminum surface and between 15 and 35nm for a titanium surface, whereby the amount of light reflected from the surface is reduced to less than about 5% of the incident radiation.

2. A method of patterning a wafer surface in an integrated circuit structure wherein the wafer surface (12) is a highly reflective metal surface and the surface is coated with an antireflective film (16) prior to forming a layer (14) of photoresist over the surface and exposing unmasked portions (22) of the photoresist to optical radiation (18) of a predetermined wavelength, characterised in that the antireflective film (16) consists of titanium nitride, and the metal surface (12) is aluminum or titanium, the titanium nitride being coated to a thickness of between 30 and 50nm when the surface is aluminum and between 15 and 35nm when the surface is titanium, and the wavelength of the optical radiation (18) being related to the thickness of the titanium nitride as follows:

| Wavelength | Metal Surface | TiN Thickness Range |
|---|---|---|
| 365nm | Al | 30–40nm |
| 405nm | Al | 35–45nm |
| 436nm | Al | 40–50nm |
| 365nm | Ti | 15–26nm |
| 405nm | Ti | 20–30nm |
| 436nm | Ti | 25–35nm |

3. A method according to claim 2 further characterised by removing the exposed portions (22) of the photoresist (14) to uncover underlying portions of the titanium nitride layer (16), removing the uncovered portions of the titanium nitride layer to uncover underlying portions of the metal surface (12), removing the uncovered portions of the metal layer to form a patterned metal layer and thereafter removing the remaining portions of the photoresist and either removing the remaining portions of the titanium nitride layer or, when the metal surface is aluminum, retaining the remaining portions of the titanium nitride layer to suppress hillock formation.

**Patentansprüche**

1. Verfahren zum Vorbereiten einer Wafer-Oberfläche (12) in einer integrierten Schaltungsstruktur zum Strukturieren durch photolithographische Verfahren, bei dem die Wafer-Oberfläche (12) eine Oberfläche aus hochreflektierendem Aluminium oder Titan ist und die Oberfläche vor dem Bilden einer Photoresist-Schicht (14) über der Oberfläche mit einem Antireflex-Film (16) beschichtet wird, dadurch gekennzeichnet, daß der Antireflex-Film (16) aus Titannitrid besteht und das Titannitrid mit einer Dicke zwischen 30 und 50 nm bei einer Aluminiumoberfläche und zwischen 15 und 35 nm bei einer Titanoberfläche aufgebracht wird, wobei die Menge an von der Oberfläche reflektiertem Licht auf weniger als ungefähr 5% der einfallenden Strahlung verringert wird.

2. Verfahren zum Strukturieren einer Wafer-Oberfläche in einer integrierten Schaltungsstruktur, bei dem die Wafer-Oberfläche (12) eine Oberfläche aus hochreflektierendem Metall ist und die Oberfläche vor dem Bilden einer Photoresist-Schicht (14) über der Oberfläche und dem Belichten nicht maskierter Bereiche (22) des Photoresists mit optischer Strahlung (18) mit einer vorbestimmten Wellenlänge mit einem Antireflex-Film (16) beschichtet wird, dadurch gekennzeichnet, daß der Antireflex-Film (16) aus Titannitrid besteht, die Metalloberfläche (12) aus Aluminium oder Titan besteht, und das Titannitrid mit einer Dicke zwischen 30 und 50 nm bei einer Aluminiumoberfläche und zwischen 15 und 35 nm bei einer Titanoberfläche aufgebracht wird, und die Wellenlänge der optischen Strahlung (18) zu der Dicke des Titannitrids im folgenden Verhältnis steht:

| Wellenlänge | Metalloberfläche | TiN-Dickenbereich |
|---|---|---|
| 365 nm | Al | 30–40 nm |
| 405 nm | Al | 35–45 nm |
| 436 nm | Al | 40–50 nm |
| 365 nm | Ti | 15–26 nm |
| 405 nm | Ti | 20–30 nm |
| 436 nm | Ti | 25–35 nm |

3. Verfahren nach Anspruch 2, ferner gekennzeichnet durch das Entfernen der belichteten Bereiche (22) des Photoresists (14), um die darunterliegenden Bereiche der Titannitridschicht (16) freizulegen, das Entfernen der freigelegten Bereiche der Titannitridschicht, um darunterliegende Bereiche der Metalloberfläche (12) freizulegen, das Entfernen der freigelegten Bereiche der Metallschicht, um eine strukturierte Metallschicht zu bilden, und das anschließende Entfernen der verbleibenden Bereiche des Photoresists und das Entfernen entweder der verbleibenden Bereiche der Titannitridschicht oder, wenn die Metalloberfläche aus Aluminium besteht, das Beibehalten der verbleibenden Bereiche der Titannitridschicht zur Vermeidung der Bildung von Ätzhügeln.

**Revendications**

1. Procédé pour préparer une surface (12) d'une pastille dans une structure à circuits intégrés pour réaliser une structuration au moyen de techniques photolithographiques, selon lequel la surface (12) de la pastille est une surface d'aluminium ou de titane très réfléchissante, et on recouvre cette surface avec une pellicule antiréfléchissante (16) avant de former une couche (14) d'une résine photosensible sur la surface, caractérisé en ce que la pellicule anti-réfléchissante (16) est constituée par du nitrure de titane, et en ce qu'on dépose le nitrure de titane sur une épaisseur comprise entre 30 et 50 nm pour une surface d'aluminium et entre 15 et 35 nm pour une surface de titane, si bien que la quantité de lumière réfléchie par la surface est réduite à moins d'environ 5% du rayonnement incident.

2. Procédé de structuration d'une surface d'une pastille dans une structure à circuits intégrés, selon lequel la surface (12) de la pastille est une surface métallique très réfléchissante, et on recouvre cette surface d'une pellicule antiréfléchissante (16) avant de former une couche (14) d'une résine photosensible sur la surface et d'exposer des parties non masquées (22) de résine photosensible à un rayonnement optique (18) possédant une longueur d'onde prédéterminée, caractérisé en ce que la pellicule antiréfléchissante (16) est constituée par du nitrure de titane et en ce que la surface métallique (12) est formée d'aluminium ou de titane, le nitrure de titane étant déposé sur une épaisseur comprise entre 30 et 50 nm, lorsque la surface est en aluminium, et entre 15 et 35 nm lorsque la surface est en titane, et la longueur d'onde du rayonnement optique (18) est associée à l'épaisseur du nitrure de titane, comme suit :

| Longueur d'onde | Surface métallique | Gamme d'épaisseur du TiN |
|---|---|---|
| 365 nm | Al | 30-40 nm |
| 405 nm | Al | 35-45 nm |
| 436 nm | Al | 40-50 nm |
| 365 nm | Ti | 15-26 nm |
| 405 nm | Ti | 20-30 nm |
| 436 nm | Ti | 25-35 nm |

3. Procédé selon la revendication 2, caractérisé en ce qu'on enlève les parties exposées (22) de la résine photosensible (14) pour découvrir des parties sous-jacentes de la couche de nitrure de titane (16), on enlève les parties découvertes de la couche de nitrure de titane pour découvrir les parties sous-jacentes de la surface métallique (12), on enlève les parties découvertes de la surface métallique pour former une couche métallique structurée, puis on enlève les parties restantes de la résine photosensible et, soit on enlève le reste des parties de la couche de nitrure de titane, soit, lorsque la surface métallique est en aluminium, on maintient des parties restantes de la couche de nitrure de titane pour réduire la formation de petites bosses.

**FIG. 1A**

**FIG. 1B**

**FIG. 1C**

INTERNAL REFLECTANCE @ λ = 436 nm
(INTO RESIST)

FIG. 2

BEST THICKNESS ~ 300 Å

FIG. 3